# FASCICULE DE BREVET EUROPEEN

(11) **EP 0 359 633 B1**
(45) Date de publication et mention de la délivrance du brevet: **01.12.1993**
(21) Numéro de dépôt: 89402445.4
(22) Date de dépôt: 07.09.1989
(51) Int. Cl.: G01R 19/04

(54) **Détectuer d'enveloppe logarithmique de signal analogique**
Logarithmischer Hüllkurvendetektor für ein analoges Signal
Logarithmic envelope detector for an analog signal

(30) Priorité: 16.09.1988 FR 8812119
(43) Date de publication de la demande: 21.03.1990
(73) Titulaire: SGS-THOMSON MICROELECTRONICS SA, 94250 Gentilly (FR)
(72) Inventeur: Nicolai, Jean, F-75116 Paris (FR)
(74) Mandataire: Ballot, Paul Denis Jacques

(56) Documents cités:
- EP-A- 0 224 935
- EP-A- 0 274 787
- ELECTRONIC DESIGN, vol. 33, no. 1, 10 janvier 1985, pages 199-218, Hasbrouck Heights, New-Jersey, US; F. GOODENOUGH: "Telecommunication integrated circuits"
- MOTOROLA TECHNICAL DEVELOPMENTS, vol. 5, no. 1, octobre 1985, pages 8-9, Motorola, Inc., Schaumburg, Illinois, US; D.E. BUSH: "A technique for voice detection in a PCM speakerphone"

## Description

L'invention concerne un détecteur d'enveloppe de signal analogique, c'est-à-dire un détecteur qui fournit un signal représentant les variations globales lentes mais non les variations instantanées du niveau d'un signal analogique appliqué à son entrée. Le signal représentant les variations globales du signal d'entrée suit en gros le contour des maxima du signal d'entrée et c'est pourquoi on parle de détecteur d'enveloppe de signal.

Toutefois, le détecteur concerné ici est un détecteur logarithmique, c'est-à-dire que les variations globales du signal sont mesurées avec une échelle logarithmique : pour les petits niveaux de signal d'entrée, les variations seront prises en compte avec un coefficient important, et plus le niveau de signal augmente, plus les variations sont prises en compte avec un coefficient multiplicateur faible.

A titre d'exemple, les détecteurs d'enveloppe logarithmique de signal sont utiles dans l'analyse de la parole; le signal dont on cherche à mesurer l'enveloppe est le signal de parole. On peut ainsi connaître le niveau sonore moyen de la parole à l'entrée. Un exemple très concret d'utilisation de détecteurs logarithmiques d'enveloppe de signal peut être trouvé dans les postes téléphoniques à écoute amplifiée : on compare le niveau moyen de signal émis sur la ligne au niveau de signal reçu de la ligne, on détermine par ailleurs si le signal émis ou reçu est plutôt du bruit ou plutôt un signal de parole utile, et on agit sur le gain des amplificateurs 3 d'émission et de réception en fonction du résultat de ces déterminations, de manière à éviter tout effet de larsen; des détecteurs d'enveloppe logarithmique servent à déterminer à chaque instant le niveau moyen émis ou reçu. Ils ont une caractéristique logarithmique pour améliorer la détection et les comparaisons pour les petits signaux sans risquer une saturation par les grands signaux.

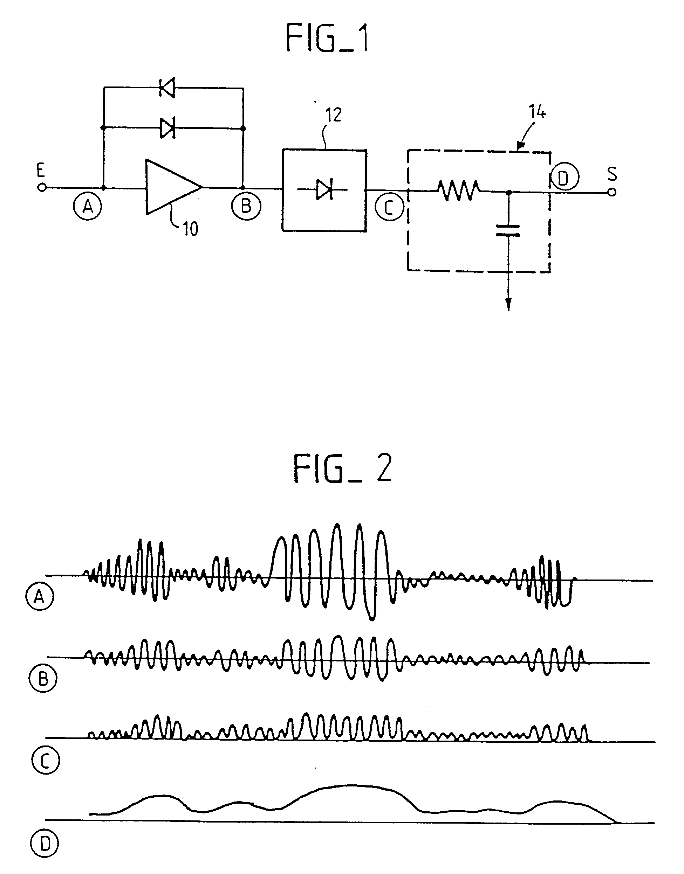

Les détecteurs d'enveloppe de signal analogique à fonction logarithmique, sont réalisés dans la technique connue selon le schéma représenté à la figure 1.

Ils comprennent essentiellement un amplificateur à gain logarithmique 10 recevant le signal analogique dont le niveau doit être contrôlé; cet amplificateur est suivi d'un redresseur double alternance 12 lorsque le signal d'entrée a des alternances positives et négatives; le redresseur est suivi d'un intégrateur RC de lissage 14, dont la constante de temps est choisie pour faire disparaître les variations rapides de signal et conserver les variations lentes de l'enveloppe.

La sortie du détecteur est prise en sortie de l'intégrateur RC.

L'amplificateur logarithmique est un amplificateur opérationnel bouclé entre sa sortie et son entrée par deux diodes en parallèle tête-bêche. Du fait que les diodes ont une courbe courant/tension logarithmique lorsqu'elles sont en direct et du fait qu'à tout instant une des diodes au moins est en direct, l'amplificateur 10 a un coefficient d'amplification logarithmique, l'amplification étant beaucoup plus importante pour les petits signaux que pour les grands.

La figure 2 représente à titre d'exemple une forme d'onde de signal analogique reçu à l'entrée du détecteur d'enveloppe de la figure 1 (ligne A); la ligne B représente le signal comprimé logarithmiquement, en sortie de l'amplificateur 10 : la dynamique de variation des signaux s'est réduite, le rapport d'amplitude entre les petits signaux et les grands est considérablement plus réduit qu'à la ligne A; la ligne C représente le signal en sortie du redresseur 12; enfin, la ligne D représente le signal de sortie de l'intégrateur RC 14; les variations rapides du signal d'entrée ont disparu, seules subsistent les variations lentes représentant l'enveloppe du signal analogique d'entrée ou son niveau moyen, mais avec une échelle logarithmique.

Dans la réalisation sous forme de circuit-intégré, fréquemment nécessaire lorsqu'on veut réduire les coûts et l'encombrement, il est parfois difficile de réaliser un tel détecteur d'enveloppe logarithmique.

En effet, on ne sait pratiquement pas le faire dans des technologies MOS standard car on ne sait pas intégrer deux diodes tête-bêche en parallèle. Or les circuits MOS sont très utiles pour toutes sortes de fonctions logiques et on se voit donc interdire la possibilité d'intégrer dans un même circuit-intégré à la fois des fonctions logiques MOS et le détecteur d'enveloppe dont on peut avoir besoin pour commander ces fonctions logiques.

Les technologies bipolaires permettent certes d'intégrer les deux diodes tête-bêche, mais on n'a pas forcément le choix de la technologie et il est dommage de se limiter a une technologie bipolaire uniquement parce que deux diodes, parmi des milliers d'autres éléments du circuit-intégré, ne peuvent pas être intégrées.

Le document EP-A-0 224 935 présente par ailleurs des détecteurs d'enveloppe sans compression logarithmique. Ils ne peuvent donc résoudre ces problèmes. Un autre document, le document EP-A-0 274 787, décrit un détecteur de crêtes qui ne peut pas non plus servir de détecteur d'enveloppe logarithmique.

De plus, que ce soit en technologie MOS ou en technologie bipolaire, le circuit de la figure 1 nécessite des capacités de valeur élevée pour le lissage, et ces capacités ne peuvent pas être intégrées.

Pour éviter les inconvénients de la technique antérieure, la présente invention propose un détecteur d'enveloppe logarithmique de signal analogique, utilisant comme élément de base un codeur analogique-numérique à compression logarithmique.

Comme on le sait, on fabrique en grande quantité des circuits appelés couramment "cofidecs" qui sont des circuits-intégrés destinés aux postes téléphoniques et qui intègrent sur une même puce de circuit-intégré une fonction de codage-décodage analogique-numérique et des fonctions de filtrage de signal.

Or le codeur analogique-numérique d'un cofidec est un codeur à compression logarithmique ou quasi logarithmique.

L'idée de la présente invention est d'utiliser ce codeur comme élément de base peu coûteux et réalisable en technologie MOS pour faire un détecteur d'enveloppe de signal analogique.

On réalisera le détecteur d'enveloppe avec un circuit identique à un cofidec standard dont on n'utilisera que la partie codeur et non la partie décodeur.

Le signal analogique dont le niveau moyen est mesuré sera appliqué à l'entrée de ce codeur; la sortie numérique du codeur, représentant l'amplitude (en valeur absolue) du signal, sera comparée au contenu d'un compteur. Si le signal analogique numérisé par le codeur est plus grand que le contenu du compteur, on incrémente le compteur, avec une fréquence relativement élevée F1; si au contraire le signal analogique numérisé devient plus faible que le contenu du compteur, on décrémente le compteur, mais avec une fréquence plus faible F2. Le contenu du compteur représente alors une approximation numérique de l'enveloppe du signal d'entrée.

Il n'y a pas besoin de redresseur comme dans la technique antérieure : le cofidec standard fournit un signal numérique dont un bit de poids fort représente le signe, et les autres bits représentent l'amplitude en valeur absolue du signal. Il suffit donc de comparer le contenu du compteur aux bits d'amplitude du signal analogique numérisé en supprimant le bit de signe.

Il n'y a pas besoin d'intégrateur RC, la fonction de détection de valeur crête accomplie à la figure 1 par l'ensemble redresseur et intégrateur RC est ici accomplie par le compteur (dont la fréquence d'incrémentation est supérieure à la fréquence de décrémentation) et le comparateur qui peuvent très facilement être totalement intégrés dans un circuit de technologie MOS. Toutefois, le signal de sortie du détecteur d'enveloppe selon l'invention est ici un signal numérique et non analogique; le plus souvent cela n'a pas d'importance car le but final est de comparer le niveau du signal d'enveloppe à une valeur déterminée ou à un autre signal, et ces comparaisons peuvent se faire sur des signaux numériques aussi bien que sur des signaux analogiques.

Selon un aspect plus détaillé de l'invention, le détecteur d'enveloppe de signal analogique comporte donc un codeur analogique-numérique à compression logarithmique ayant des bornes d'entrée de signal analogique et des bornes de sortie de signal numérique, un compteur numérique ayant une entrée de comptage et une entrée de décomptage, un comparateur numérique raccordé d'une part aux bornes de sortie numériques du codeur et d'autre part aux sorties du compteur, et un circuit logique de commande relié à la sortie du comparateur et apte à commander l'incrémentation du compteur à une première fréquence ou la décrémentation du compteur à une deuxième fréquence différente de la première selon l'état du compteur, la sortie du détecteur étant reliée aux sorties du compteur, la première fréquence étant largement supérieure à la deuxième.

La fréquence de comptage sera en principe plus élevée que la fréquence de décomptage; par exemple elle est huit fois plus élevée.

La fréquence de comptage dépend de la vitesse à laquelle on veut que le compteur suive les variations du signal d'entrée.

La fréquence de décomptage sera d'autant plus basse qu'on veut des variations plus lentes du signal d'enveloppe; elle agit comme la fréquence de coupure de l'intégrateur RC de la figure 1.

D'autres caractéristiques et avantages de l'invention apparaîtront à la lecture de la description détaillée qui suit et qui est faite en référence aux dessins annexés dans lesquels :
- la figure 1 déjà décrite représente la technique antérieure;
- la figure 2 illustre les formes d'onde de signal dans le circuit de la figure 1;
- la figure 3 représente un détecteur d'enveloppe de signal analogique selon l'invention.
- la figure 4 représente la courbe de conversion standard d'un cofidec, montrant la compression logarithmique de l'entrée analogique vers la sortie numérique.

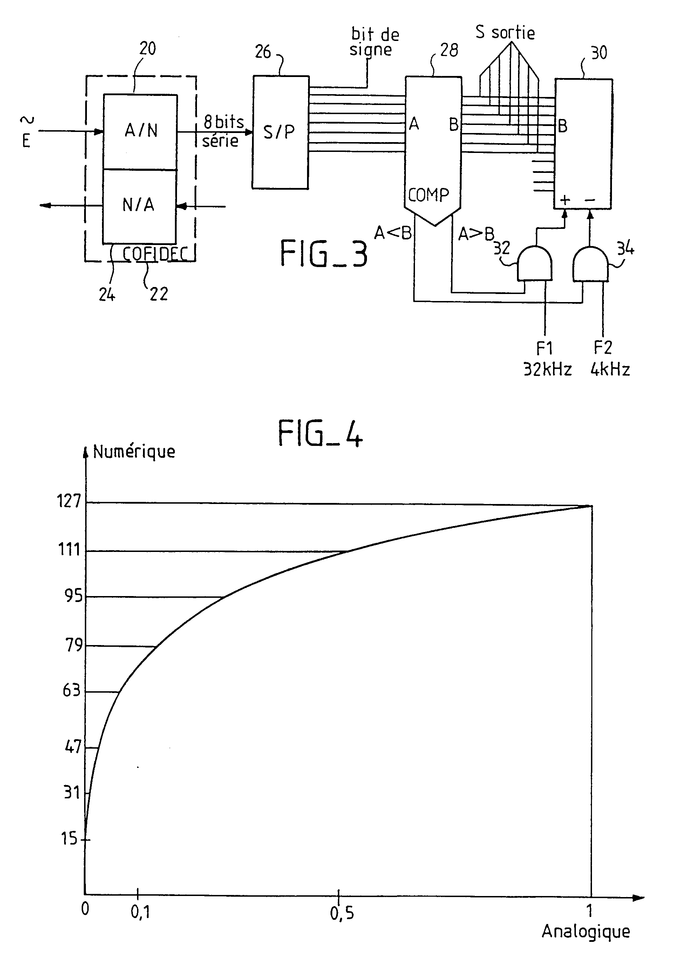

Le signal analogique dont on veut contrôler le niveau moyen est appliqué à une entrée E du détecteur d'enveloppe représenté à la figure 3.

Le détecteur comprend un codeur analogique-numérique à compression logarithmique, désigné par la référence 20. Ce codeur peut être constitué par une partie d'un circuit cofidec classique 22 dont l'autre partie 24, inutilisée ici, est un codeur numérique-analogique. Les cofidecs utilisés dans les postes téléphoniques conviennent parfaitement puisqu'ils ont une caractéristique de conversion avec compression logarithmique. On utilisera soit le cofidec entier qui a l'avantage d'être un circuit standard peu coûteux, le codeur numérique-analogique restant inutilisé, ou bien uniquement un circuit 20 identique à la partie codeur analogique-numérique d'un cofidec.

Le codeur 20 a un côté d'entrée analogique et un coté de sortie numérique.

L'entrée E est reliée à l'entrée analogique du codeur 20. La sortie est une sortie série binaire, les mots binaires étant codés par exemple sur huit bits dont un bit de signe. On reviendra plus loi sur le codage du signal analogique d'entrée.

La sortie série est appliquée à l'entrée d'un convertisseur série-parallèle 26 qui transforme chaque mot de huit bits série en un mot de huit bits parallèle. Bien entendu ce convertisseur série- parallèle n'est pas nécessaire dans le cas où la sortie du codeur 20 serait directement une sortie parallèle; cela est envisageable bien que les cofidecs actuels aient plutôt une sortie série.

Les huit sorties parallèles du convertisseur 26 comprennent une sortie fournissant un bit de signe du signal analogique; cette sortie n'est pas utilisée pour la détection d'enveloppe de signal. Les sept autres sorties définissent selon un code binaire l'amplitude en valeur absolue du signal analogique comprimé logarithmiquement.

Le codage binaire de l'amplitude du signal analogique est représenté pour un cofidec standard à la figure 4.

En abscisse on a porté l'amplitude du signal selon une échelle linéaire (arbitraire : on considère une amplitude minimale 0 et une amplitude maximale 1); en ordonnée on a porté, également selon une échelle linéaire, une représentation numérique décimale de la sortie binaire. Autrement dit, alors que les sept bits de sortie peuvent prendre toutes les valeurs binaires entre 0000000 et 1111111, ces valeurs ont été représentées par des nombres décimaux correspondants de 0 à 127.

Comme on le voit, une courbe de forme globalement logarithmique (mais variant en escalier) représente la valeur numérique du code binaire de sortie en fonction de l'amplitude du signal analogique d'entrée.

La courbe logarithmique est divisée en huit segments de droite. Les segments sont codés par les trois bits de poids fort de la sortie binaire; par conséquent le premier segment correspond aux valeurs numériques 0 à 15, le deuxième aux valeurs numériques 16 à 31, le troisième 32 à 47, etc. jusqu'au huitième pour les valeurs 111 à 127.

Le codage des trois bits définissant le segment correspondant à une gamme d'amplitudes données est sensiblement logarithmique, en ce sens que pour respecter la forme sensiblement logarithmique de la courbe tracée sur la figure 4, les segments successifs ont des pentes variant en progression logarithmique; on voit clairement sur la figure 4 que pour les très petits signaux (inférieurs à 1% du maximum), la pente est très forte, alors que pour les grands signaux elle est très faible. Pratiquement le premier segment de droite ne sert à coder que les signaux d'amplitude comprise entre 0 et 1% du maximum, alors que le dernier segment sert à lui seul à coder les signaux d'amplitude comprise entre 50 et 100% du maximum.

A l'intérieur de chaque segment de droite, les quatre bits de poids faible servent à définir la valeur précise du signal analogique; cette fois le codage est linéaire et non logarithmique, c'est-à-dire que si le signal analogique est incrémenté d'un pas donné (16 pas identiques pour parcourir la totalité du segment), alors la valeur numérique est incrémentée d'une unité (un bit de poids faible).

Revenant à la figure 3, le détecteur d'enveloppe comporte encore un comparateur numérique 28 à sept bits, et un compteur numérique 30.

Les sorties parallèles du convertisseur 26 sont connectées d'un côté du comparateur 28; les sept sorties de poids fort du compteur 30 sont connectées de l'autre côté du comparateur 28.

Le compteur 30 est par exemple un compteur à 11 bits. Il possède une entrée de comptage (+) et un entrée de décomptage (-).

Le comparateur 28 possède deux sorties (ou une sortie et un circuit logique pour établir deux sorties complémentaires); l'une des sorties fournit un signal d'autorisation d'incrémentation du compteur lorsque l'amplitude numérisée logarithmiquement A du signal analogique est supérieure au contenu B du compteur 30 (défini à partir de ses sept bits de poids fort); l'autre sortie fournit un signal d'autorisation de décrémentation du compteur lorsque l'amplitude numérisée A du signal analogique est inférieure au contenu B du compteur.

Une horloge d'incrémentation à fréquence F1 est appliquée à l'entrée d'incrémentation du compteur à travers une porte de validation 32 contrôlée par le signal d'incrémentation en sortie du comparateur. Inversement, une horloge de décrémentation à fréquence F2 est appliquée à l'entrée de décrémentation à travers une porte 34 de validation contrôlée par le signal de décrémentation en sortie du comparateur.

La fréquence d'incrémentation F1 est beaucoup plus élevée que la fréquence de décrémentation F2.

Dans un exemple où le codeur analogique-numérique fournit un mot de huit bits toutes les 125 millisecondes (fréquence de conversion 8 kilohertz), on peut prendre une fréquence d'incrémentation de 32 kilohertz et une fréquence de décrémentation de 4 kilohertz.

La sortie du détecteur d'enveloppe est une sortie numérique prise sur les sept bits de poids fort du compteur 30.

Le circuit fonctionne de la manière suivante: si le signal analogique croît de sorte que sa valeur numérisée logarithmiquement A dépasse le niveau indiqué par les sept bits de poids fort du compteur, le compteur s'incrémente rapidement et le compteur tend à suivre le niveau du signal, avec un temps de réponse limité toutefois par la fréquence de comptage; lorsque le signal analogique redevient inférieur au contenu du compteur, soit parce que le contenu du compteur finit par rattraper le signal analogique, soit parce que le signal analogique est redescendu, le compteur est décrémenté, mais très lentement, de sorte que le compteur garde en mémoire avec une constante de temps importante le niveau maximal précédemment atteint par le signal analogique. C'est en ce sens que la sortie du détecteur représente (sous forme numérique) l'enveloppe des variations lentes du signal analogique.

Le détecteur d'enveloppe selon l'invention sera de préférence intégré en technologie MOS avec d'autres circuits; comme on le voit, il ne nécessite aucune capacité contrairement à celui de la figure 1. Les constantes de temps sont définies par les fréquences d'horloge, ce qui est beaucoup plus précis que des valeurs de capacités, de résistances, ou de courants.

## Revendications

1. Détecteur d'enveloppe logarithmique de signal analogique, caractérisé en ce qu'il comporte un codeur analogique-numérique (20) à compression logarithmique ayant des bornes d'entrée de signal analogique et des bornes de sortie de signal numérique, un compteur numérique (30) ayant une entrée de comptage et une entrée de décomptage, un comparateur numérique (28) raccordé d'une part aux bornes de sortie numériques du codeur (20) et d'autre part aux sorties du compteur (30), et un circuit logique de commande (32, 34) relié à la sortie du comparateur et apte à commander l'incrémentation du compteur à une première fréquence (F1) ou la décrémentation du compteur à une deuxième fréquence (F2) différente de la première selon l'état du compteur, la sortie du détecteur étant reliée aux sorties du compteur, la première fréquence (F1) étant largement supérieure à la deuxième (F2).

2. Détecteur selon la revendication 1, caractérisé en ce que le codeur (20) est le codeur analogique-numérique d'un circuit standard cofidec.

3. Détecteur selon l'une des revendications 1 à 2, caractérisé en ce que le codeur (20) fournit des mots binaires ayant d'une part un bit de signe et d'autre part des bits définissant l'amplitude en valeur absolue du signal analogique, seuls ces derniers étant appliqués au comparateur (28).

4. Détecteur selon l'une des revendications 1 à 3, caractérisé en ce que le compteur (20) comporte des sorties de poids fort et des sorties de poids faible, seules les sorties de poids fort étant appliquées au comparateur (28).

## Claims

1. A detector for the logarithmic envelope of an analog signal, characterised in that it includes an analog-digital coder (20) with logarithmic compression having analog signal input ports and digital signal output ports, a digital counter (30) having a counting-up input and a counting-down input, a digital comparator (28) connected firstly to the digital output ports of the coder (20) and secondly to the outputs of the counter (30), and a logic control circuit (32, 34) connected to the output of the comparator and adapted to control incremental operation of the counter at a first frequency (F1) or decremental operation of the counter at a second frequency (F2) different from the first, depending on the state of the counter, the output of the detector being connected to the outputs of the counter, the first frequency (F1) being substantially greater than the second (F2).

2. A detector according to Claim 1, characterised in that the coder (20) is the analog-digital coder of a standard code-filter-decode (COFIDEC) integrated circuit.

3. A detector according to Claim 1 or Claim 2, characterised in that the coder (20) supplies binary words having firstly a sign bit and secondly, bits defining the amplitude of the analog signal in absolute values, only these latter being applied to the comparator (28).

4. A detector according to one of Claims 1 to 3, characterised in that the counter (20) has heavy weight outputs and light weight outputs, only the heavy weight outputs being applied to the comparator (28).

## Patentansprüche

1. Logarithmischer Analogsignal-Hüllkurvendetektor, dadurch **gekennzeichnet,** daß er umfaßt einen Analog-Digitalkodierer (20) mit logarithmischer Kompression, der Analogsignal-Eingangsanschlüsse und Digitalsignal-Ausgangsanschlüsse aufweist, einen digitalen Zähler (30), der einen Zähleingang und einen Abwärtszähleingang aufweist, einen Digitalkomparator (28), der zum einen an die digitalen Ausgangsanschlüsse des Kodierers (20) und zum anderen an die Ausgänge des Zählers (30) angeschlossen ist, und einen Logiksteuerkreis (32, 34), der mit dem Ausgang des Komparators verbunden ist und in der Lage ist, gemäß dem Zustand des Zählers die Inkrementierung des Zählers mit einer ersten Frequenz (F1) oder die Herabsetzung des Zählers mit einer von der ersten verschiedenen zweiten Frequenz (F2) zu steuern, wobei der Ausgang des Detektors mit den Ausgängen des Zählers verbunden ist, wobei die erste Frequenz (F1) weit höher als die zweite (F2) ist.

2. Detektor nach Anspruch 1, dadurch **gekennzeichnet,** daß der Kodierer (20) der Analog-Digitalkodierer eines Cofidec-Standardkreises ist.

3. Detektor nach einem der Ansprüche 1 bis 2, dadurch **gekennzeichnet**, daß der Kodierer (20) Binärwörter liefert, die zum einen ein Vorzeichenbit und zum anderen Bits aufweisen, die die Amplitude als Absolutwert des Analogsignals festlegen, wobei lediglich die letzteren auf den Komparator (28) gegeben werden.

4. Detektor nach einem der Ansprüche 1 bis 3, dadurch **gekennzeichnet,** daß der Zähler (20) Ausgänge hoher Wertigkeit und Ausgänge niedriger Wertigkeit umfaßt, wobei lediglich die Ausgänge hoher Wertigkeit auf den Komparator (28) gegeben werden.
